# EUROPEAN PATENT APPLICATION

(11) **EP 4 692 986 A1**
(43) Date of publication of application: **11.02.2026**
(21) Application number: 25188444.1
(22) Date of filing: 09.07.2025
(51) Int. Cl.: G06F 1/16

(54) **DISPLAY DEVICE**

(30) Priority: 09.08.2024 KR 20240106666
(71) Applicant: Samsung Display Co., Ltd., Yongin-si, Gyeonggi-do 17113 (KR)
(72) Inventor: Park, Soon Nyung, 17113 Giheung-gu, Yongin-si, Gyeonggi-do (KR); Kim, Hun Tae, 17113 Giheung-gu, Yongin-si, Gyeonggi-do (KR); Kim, Jong Hyuck, 17113 Giheung-gu, Yongin-si, Gyeonggi-do (KR); Kim, Hyeon Ji, 17113 Giheung-gu, Yongin-si, Gyeonggi-do (KR); Bae, Gyum Dong, 17113 Giheung-gu, Yongin-si, Gyeonggi-do (KR)
(74) Representative: Dr. Weitzel & Partner

(57) **Abstract**

A display device includes, a display panel, a panel support layer disposed under a lower surface of the display panel in a first direction that is a thickness direction of the display panel, and a shielding film disposed under a lower surface of the panel support layer in the first direction, where the shielding film includes at least one removal area that is at least one opening exposing the lower surface of the panel support layer.

## Description

The present invention relates to a display device.

As the information society develops, the demand for display devices for displaying images has increased and diversified. The display devices may be display devices such as liquid crystal displays (LCDs), field emission displays (FEDs), or light emitting displays (LEDs). The light emitting display may include an organic light emitting display including organic light emitting diode elements as light emitting elements, an inorganic light emitting display including inorganic light emitting diode elements as light emitting elements, or the like.

Recently, in order to increase portability of the display devices and provide wide display screens, bendable display devices in which a display area may be bent or foldable display devices in which a display area may be folded have been released.

Aspects of the present invention provide a display device having improved heat dissipation characteristics.

Aspects of the present invention also provide a display device in which the generation of bubbles in an adhesive member is minimized.

However, aspects of the present invention are not restricted to those set forth herein. The above and other aspects of the present invention will become more apparent to one of ordinary skill in the art to which the present invention pertains by referencing the detailed description of the present invention given below.

The invention is defined by claim 1. The dependent claims and the description provide preferred embodiments.

According to an aspect of the present invention, there is provided a display device including, a display panel, a panel support layer disposed under a lower surface of the display panel in a first direction that is a thickness direction of the display panel, and a shielding film disposed under a lower surface of the panel support layer in the first direction, wherein the shielding film includes at least one removal area that is at least one opening exposing the lower surface of the panel support layer. The first direction is referred to as the third direction in the description of the figures.

In an embodiment, the panel support layer may include a folding portion and a non-folding portion disposed on at least one side of the folding portion in a second direction different from the first direction, and the removal area includes a first removal area disposed on the non-folding portion and a second removal area disposed adjacent to a boundary between the folding portion and the non-folding portion. The second direction is referred to as another direction in the claims. The second direction may be also termed as a plane direction, and may be for example one of the first or second directions in the description of the figures, or may be a direction different from the first and second directions in a plane defined by the first and second directions.

In an embodiment, one end of the first removal area may be in contact with one side of the non-folding portion opposite to the boundary in the second direction.

In an embodiment, the first removal area and the second removal area may extend in different directions from each other. The second removal area is referred to as a third removal area in the description of the figures.

In an embodiment, the first removal area and the second removal area may be connected to each other.

In an embodiment, the removal area may further include a third removal area disposed on the non-folding portion. The third removal area is referred to as a second removal area in the description of the figures.

In an embodiment, the third removal area may be connected to at least one of the first removal area and the second removal area.

In an embodiment, the first removal area may be provided in plurality, and the removal area may further include a fourth removal area connecting at least two adjacent first removal areas of the plurality of first removal areas to each other.

In an embodiment, at least a portion of the fourth removal area mat include a curved line on in a view in the first direction.

In an embodiment, the display device may further include a circuit board disposed under a lower surface of the shielding film in the first direction, and an adhesive member disposed between the shielding film and the circuit board in the first direction.

In an embodiment, the adhesive member may include a first adhesive member that does not overlap the removal area in the first direction and a second adhesive member that overlaps the removal area in the first direction, and the second adhesive member may be spaced apart from the panel support layer with the removal area interposed therebetween in the first direction.

In an embodiment, the first adhesive member may be a double-sided attachment type and the second adhesive member may be a single-sided attachment type.

In an embodiment, the adhesive member may be disposed in an area other than an area overlapping the removal area in the first direction.

In an embodiment, the shielding film may be a plating layer including copper, titanium, and/or an alloy thereof.

In an embodiment, the shielding film may be formed by physical vapor deposition.

In an embodiment, the shielding film may have a thickness of 1 µm to 5 µm in the first direction.

According to an aspect of the present invention, there is provided a display device including, a display panel including a sub-area bendable in a first direction that is a thickness direction, a panel support layer disposed under a lower surface' of the display panel in the first direction, a shielding film disposed under a lower surface of the panel support layer in the first direction, and a circuit board overlapping the sub-area and disposed under a lower surface of the shielding film in the first direction when the display panel is bent, where the shielding film includes at least one removal area that is at least one opening exposing the lower surface of the panel support layer.

In an embodiment, one end of the removal area is in contact with one side of the panel support layer in a second direction different from the first direction.

In an embodiment, the display device may further comprise an adhesive member disposed between the shielding film and the circuit board in the first direction, wherein the adhesive member is spaced apart from the panel support layer with the removal area interposed therebetween in the first direction.

In an embodiment, the display device may further comprise an adhesive member disposed between the shielding film and the circuit board in the first direction, wherein the adhesive member is disposed in an area other than an area overlapping the removal area.

According to an aspect of the present invention, there is provided an electronic device including a display device; and a power supply configured to provide power to the display device, where the display device includes: a display panel including a first surface and a second surface respectively positioned on one side and the other side in a first direction, a window disposed on the first surface of the display panel in the first direction, an upper protective film disposed on the window in the first direction, a lower protective film disposed on the second surface of the display panel in the first direction, a panel support layer disposed on the lower protective film in the first direction, and a shielding film disposed on the panel support layer, wherein the shielding film includes at least one removal area exposing a surface positioned on the other side of the panel support layer in the first direction.

In an embodiment, one end of the removal area is in contact with one side of the panel support layer in a second direction different from the first direction.

With a display device according to an embodiment of the present invention, heat dissipation characteristics may be improved.

With the display device according to an embodiment of the present invention, the generation of bubbles in an adhesive member may be minimized.

The effects of the present invention are not limited to the aforementioned effects, and various other effects are included in the present specification.

### BRIEF DESCRIPTION OF THE DRAWINGS

The above and other aspects and features of the present invention will become more apparent by describing in detail embodiments thereof with reference to the attached drawings, in which:
FIG. 1 is a perspective view illustrating an unfolded state of a display device according to an embodiment;
FIG. 2 is a perspective view illustrating a folded state of the display device according to an embodiment;
FIG. 3 is a perspective view illustrating an unfolded state of a display device according to another embodiment;
FIG. 4 is a perspective view illustrating a folded state of the display device according to another embodiment;
FIG. 5 is a cross-sectional view illustrating the display device according to an embodiment;
FIG. 6 is a cross-sectional view illustrating an example of a display panel according to an embodiment;
FIG. 7 is a plan view illustrating a panel support layer according to an embodiment;
FIG. 8 is a rear view illustrating the display device according to an embodiment;
FIG. 9 is a rear view illustrating a state in which the display device of FIG. 8 is bent;
FIG. 10 is a table illustrating results of a reliability test of the display device according to a degree of disposition and removal of a shielding film according to an embodiment;
FIG. 11 is a schematic cross-sectional view illustrating an example of the display device taken along line X1-X1' of FIG. 9;
FIG. 12 is a schematic cross-sectional view illustrating another example of the display device taken along line X1-X1' of FIG. 9;
FIG. 13 is a rear view illustrating a display device according to another embodiment;
FIG. 14 is a rear view illustrating a display device according to still another embodiment;
FIG. 15 is a rear view illustrating a display device according to still another embodiment;
FIG. 16 is a rear view illustrating a display device according to still another embodiment;
FIG. 17 is a rear view illustrating a display device according to still another embodiment;
FIG. 18 is a rear view illustrating a display device according to still another embodiment;
FIG. 19 is a rear view illustrating a display device according to still another embodiment;
FIG. 20 is a rear view illustrating a display device according to still another embodiment;
FIG. 21 is a rear view illustrating a display device according to still another embodiment; and
FIG. 22 is a block diagram illustrating an electronic device according to an embodiment.

The invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Hereinafter, embodiments of the present invention will be described in detail with reference to the accompanying drawings.

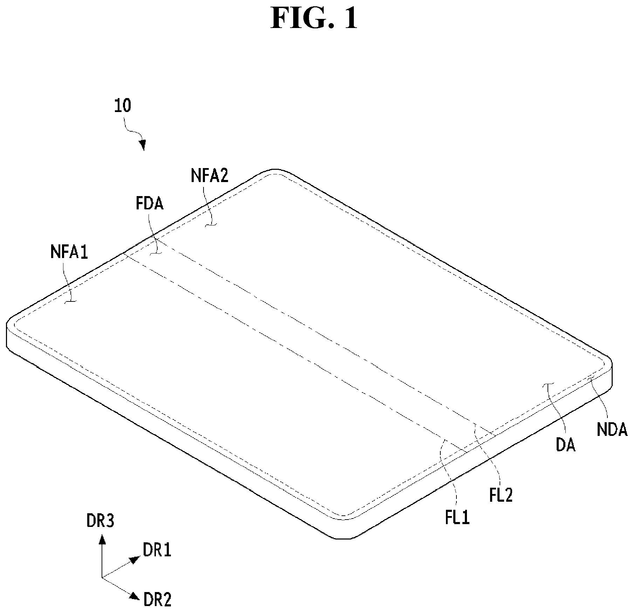

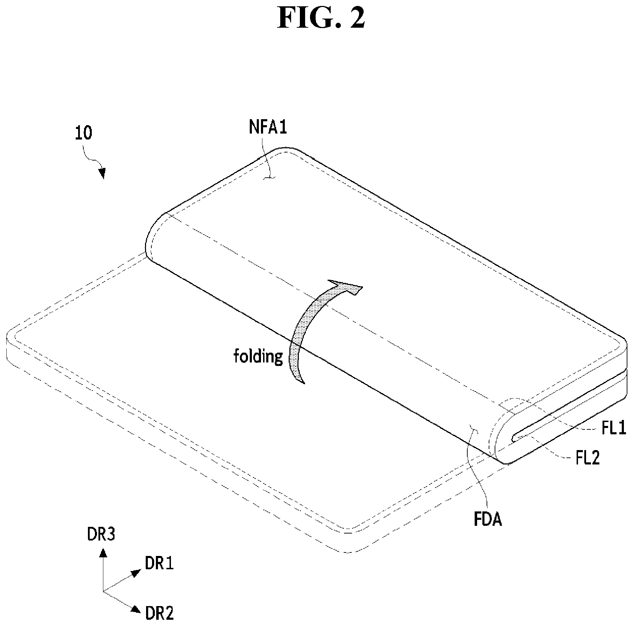

FIG. 1 is a perspective view illustrating an unfolded state of a display device according to an embodiment. FIG. 2 is a perspective view illustrating a folded state of the display device according to an embodiment.

Referring to FIGS. 1 and 2, a first state of a display device 10 that is not folded at folding lines FL1 and FL2 and is unfolded is illustrated in FIG. 1, and a second state of the display device 10 that is folded at the folding lines FL1 and FL2 is illustrated in FIG. 2.

The display device 10 according to an embodiment may be a foldable display device. It will be mainly described that the display device 10 according to an embodiment is applied to a smartphone, but the present invention is not limited thereto. For example, the display device 10 according to embodiments of the present invention is a device that displays a moving image or a still image, and may be used as a display screen of various products such as televisions, laptop computers, monitors, billboards, and the Internet of Things (IOT) as well as portable electronic devices such as mobile phones, smartphones, tablet personal computers (PCs), smart watches, watch phones, mobile communication terminals, electronic notebooks, electronic books, portable multimedia players (PMPs), navigation devices, and ultra mobile PCs (UMPCs).

The display device 10 according to an embodiment may be variously classified according to a display method. For example, the display device 10 may include an organic light emitting display, an inorganic light emitting display, a quantum dot light emitting display, a micro light emitting diode (LED) display, a nano LED display, a field emission display, an electrophoretic display, and the like. Hereinafter, an organic light emitting display will be described as an example of the display device, and unless a special distinction is required, an organic light emitting display applied to an embodiment will be simply abbreviated as a display device. However, an embodiment is not limited to the organic light emitting display, and other display devices listed above or known in the present technical field may also be applied within the scope of the technical idea.

In the accompanying drawings, a first direction DR1 is a direction parallel to one side of the display device 10 in a plan view, and may be, for example, a transverse direction of the display device 10. A second direction DR2 is a direction parallel to another side of the display device 10 in contact with one side of the display device 10 in a plan view, and may be a longitudinal direction of the display device 10. A third direction DR3 may be a thickness direction of the display device 10. As used herein, the "plan view" is a view in the third direction DR3.

The first direction DR1 and the second direction DR2 are horizontal directions, respectively, and may cross each other. For example, the first direction DR1 and the second direction DR2 may be orthogonal to each other. In addition, the third direction DR3 may be a perpendicular direction crossing, for example, orthogonal to, the first direction DR1 and the second direction DR2. Unless otherwise defined, directions indicated by arrows of the first to third directions DR1, DR2, and DR3 may be referred to as one side, and directions opposite to one side may be referred to as the other side. In addition, the terms "on", "upper side", "upper portion", "top, and "upper surface" as used herein refer to a direction toward which an arrow of the third direction DR3 is directed in the drawings, and the terms "below", "lower side", "lower portion", "bottom, and "lower surface" used as herein refer to a direction opposite to the direction toward which the arrow of the third direction DR3 is directed in the drawings.

The display device 10 may have a rectangular or square shape in a plan view. However, the present invention is not limited thereto, and in some embodiments, the display device 10 may have a rectangular shape with vertical corners or a rectangular shape with rounded corners in a plan view. The display device 10 may include two short sides disposed in the first direction DR1 and two long sides disposed in the second direction DR2 in a plan view.

The display device 10 includes a display area DA and a non-display area NDA. In a plan view, a shape of the display area DA may correspond to the shape of the display device 10. For example, when the display device 10 has the rectangular shape in a plan view, the display area DA may also have a rectangular shape.

The display area DA may be an area displaying an image by including a plurality of pixels. The plurality of pixels may be arranged in a matrix direction. The plurality of pixels may have a rectangular shape, a rhombic shape, or a square shape in a plan view, but are not limited thereto. For example, the plurality of pixels may have quadrangular shapes other than the rectangular shape, the rhombic shape, or the square shape, polygonal shapes other than the quadrangular shapes, a circular shape, or an elliptical shape in a plan view.

The non-display area NDA may be an area that does not display an image because it does not include pixels. The non-display area NDA may be disposed around the display area DA. The non-display area NDA may be disposed to surround the display area DA as illustrated in FIGS. 1 and 2, but is not limited thereto. The display area DA may be partially surrounded by the non-display area NDA.

The display device 10 may be maintained in both a first state, which is an unfolded state, and a second state, which is a folded state. The display device 10 may be folded in an in-folding manner in which the display areas DA are disposed inside while facing each other as illustrated in FIG. 2. When the display device 10 is folded in the in-folding manner, front surfaces of the display device 10 may face each other. Alternatively, the display device 10 may be folded in an out-folding manner in which the display areas DA are positioned on opposite sides and are disposed outside. When the display device 10 is folded in the out-folding manner, rear surfaces of the display device 10 may face each other.

The display device 10 may include a folding area FDA, a first non-folding area NFA1, and a second non-folding area NFA2. The folding area FDA may be an area where the display device 10 is bent or folded, and the first non-folding area NFA1 and the second non-folding area NFA2 may be areas where the display device 10 is not bent or folded. In an embodiment, the first non-folding area NFA1 and the second non-folding area NFA2 may be flat areas of the display device 10, but are not limited thereto.

The first non-folding area NFA1 may be disposed on one side, for example, the left side, of the folding area FDA. The second non-folding area NFA2 may be disposed on the other side, for example, the right side, of the folding area FDA. Here, the left side may refer to the other side in the first direction DR1, and the right side may refer ton one side in the first direction DR1.

The folding area FDA is an area defined by a first folding line FL1 and a second folding line FL2, and may be an area where the display device 10 is bent with a predetermined curvature. The first folding line FL1 may be a boundary between the folding area FDA and the first non-folding area NFA1, and the second folding line FL2 may be a boundary between the folding area FDA and the second non-folding area NFA2.

As illustrated in FIGS. 1 and 2, the first folding line FL1 and the second folding line FL2 may extend in the second direction DR2, and in this case, the display device 10 may be folded along the first direction DR1. For this reason, a length of the display device 10 in the first direction DR1 may be reduced by approximately half, and thus, a user may conveniently carry the display device 10.

When the first folding line FL1 and the second folding line FL2 extend in the second direction DR2, a length of the folding area FDA in the second direction DR2 may be greater than a length of the folding area FDA in the first direction DR1. In addition, a length of the first non-folding area NFA1 in the second direction DR2 may be greater than a length of the first non-folding area NFA1 in the first direction DR1. A length of the second non-folding area NFA2 in the second direction DR2 may be greater than a length of the second non-folding area NFA2 in the first direction DR1.

Each of the display area DA and the non-display area NDA may overlap at least one of the folding area FDA, the first non-folding area NFA1, and the second non-folding area NFA2. It has been illustrated in FIGS. 1 and 2 that each of the display area DA and the non-display area NDA overlaps the folding area FDA, the first non-folding area NFA1, and the second non-folding area NFA2.

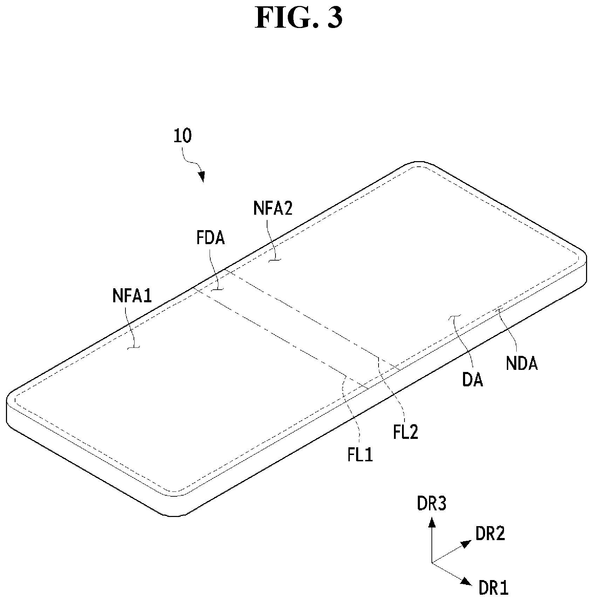

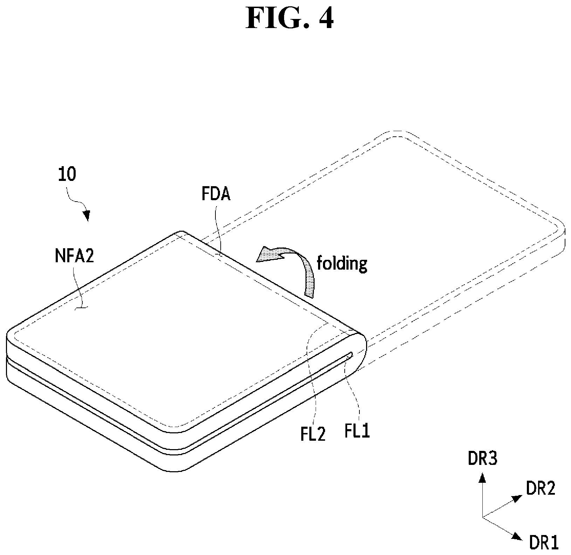

FIG. 3 is a perspective view illustrating an unfolded state of a display device according to another embodiment. FIG. 4 is a perspective view illustrating a folded state of the display device according to another embodiment.

Referring to FIGS. 3 and 4, a first state of a display device 10 that is not folded at folding lines FL1 and FL2 and is unfolded is illustrated in FIG. 3, and a second state of the display device 10 that is folded at the folding lines FL1 and FL2 is illustrated in FIG. 4.

In the first state in which the display device 10 is unfolded, long sides of the display device 10 may extend along the second direction DR2, and short sides of the display device 10 may extend along the first direction DR1.

In the display device 10 according to another embodiment illustrated in FIGS. 3 and 4, the first folding line FL1 and the second folding line FL2 may extend along the first direction DR1, and the display device 10 may be folded along the second direction DR2.

The first non-folding area NFA1 may be disposed on one side, for example, the lower side, of the folding area FDA. The second non-folding area NFA2 may be disposed on the other side, for example, the upper side, of the folding area FDA. Here, the upper side may refer to the other side in the second direction DR2, and the lower side may refer ton one side in the second direction DR2.

When the first folding line FL1 and the second folding line FL2 extend in the first direction DR1 as illustrated in FIGS. 3 and 4, a length of the folding area FDA in the first direction DR1 may be greater than a length of the folding area FDA in the second direction DR2. In addition, a length of the first non-folding area NFA1 in the second direction DR2 may be greater than a length of the first non-folding area NFA1 in the first direction DR1. A length of the second non-folding area NFA2 in the second direction DR2 may be greater than a length of the second non-folding area NFA2 in the first direction DR1.

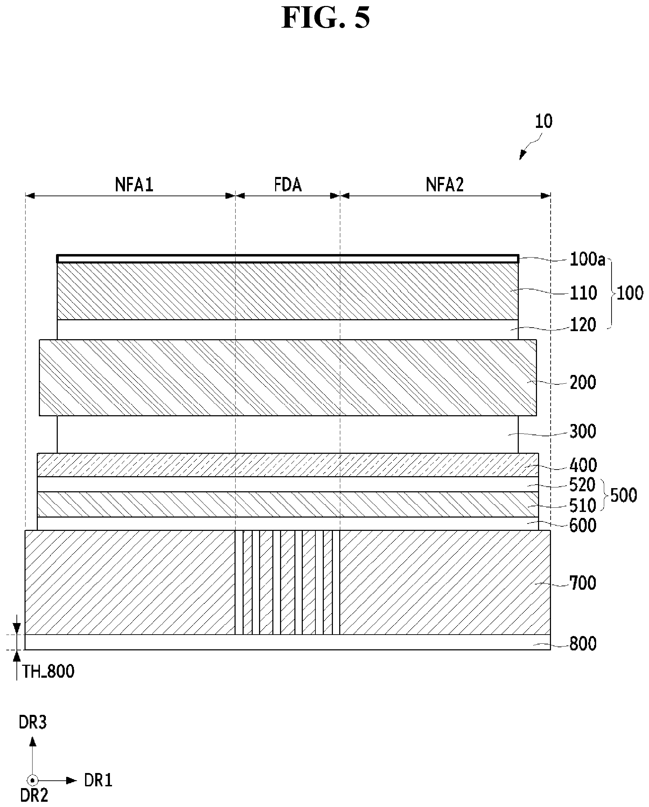

FIG. 5 is a cross-sectional view illustrating the display device according to an embodiment.

Referring to FIG. 5, the display device 10 according to an embodiment may include an upper protective film 100, a window 200, a second adhesive layer 300, a display panel 400, a lower protective film 500, a fourth adhesive layer 600, a panel support layer 700, and a shielding film 800.

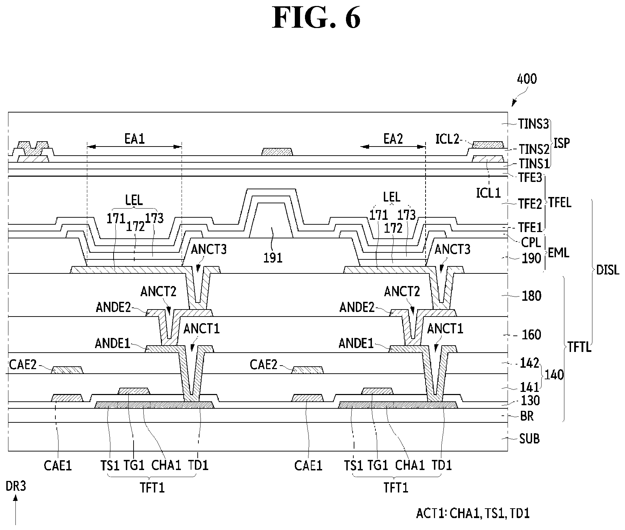

The display panel 400 may be a panel that displays an image. The display panel 400 may be an organic light emitting display panel including an organic light emitting layer, a quantum dot light emitting display panel including a quantum dot light emitting layer, an inorganic light emitting display panel using inorganic semiconductor elements as light emitting elements, and a micro light emitting display panel using micro light emitting diodes as light emitting elements. Hereinafter, it will be mainly described that the display panel 400 is an organic light emitting display panel, but the present invention is not limited thereto. The display panel 400 will be described later with reference to FIG. 6.

The window 200 may be disposed on one surface of the display panel 400. For example, the window 200 may be disposed on an upper surface of the display panel 400. The window 200 may protect the display panel 400 from external impact. The window 200 may enhance impact resistance of the display device 10.

The window 200 may be made of a transparent material. For example, the window 200 may be glass or plastic. In some embodiments, the window 200 may be ultra-thin glass (UTG) having a thickness of 0.1 mm or less. Alternatively, the window 200 may be a transparent polyimide film.

The second adhesive layer 300 may be disposed below the window 200. For example, the second adhesive layer 300 may be disposed between the window 200 and the display panel 400. The window 200 and the display panel 400 may be adhered to each other through the second adhesive layer 300. The second adhesive layer 300 may include a transparent adhesive such as a pressure sensitive adhesive (PSA) or an optically clear adhesive (OCA). Alternatively, the second adhesive layer 300 may include an acrylic adhesive material.

The upper protective film 100 may be disposed on the window 200. The upper protective film 100 may include an upper protective layer 110, a coating film 100a, and a first adhesive layer 120.

The upper protective layer 110 may perform at least one of an impact absorption function, an anti-scratch function, an anti-fingerprint function, an anti-glare function, and an anti-scattering function of the window 220. The upper protective layer 110 may include a material having high flexibility and resistant to a scratch. For example, the upper protective layer 110 may be a polymer film such as polyethylene terephthalate or a tempered glass film.

The coating film 100a may be disposed on the upper protective layer 110. For example, the coating film 100a may be disposed on an upper surface of the upper protective layer 110. The coating film 100a may be a low-reflection and anti-fingerprint (LRAF) coating film.

The first adhesive layer 120 may be disposed below the upper protective layer 110. For example, the first adhesive layer 120 may be disposed between the upper protective layer 110 and the window 200. The upper protective layer 110 and the window 200 may be adhered to each other through the first adhesive layer 120. The first adhesive layer 120 may include a transparent adhesive such as a pressure sensitive adhesive (PSA) or an optically clear adhesive (OCA). Alternatively, the first adhesive layer 120 may include an acrylic adhesive material.

The first adhesive layer 120 may be handled in a state in which it is attached to the upper protective layer 110 in a process such as storage and transport of the upper protective film 100. Before the first adhesive layer 120 is attached to the window 200, a release film may be disposed on a lower surface (i.e., lower surface) of the first adhesive layer 120. The release film may be attached to the lower surface of the first adhesive layer 120 when the upper protective film 100 is handled, and may be removed when the first adhesive layer 120 is attached to the window 200.

The lower protective film 500 may be disposed on the other surface of the display panel 400. For example, the lower protective film 500 may be disposed on a lower surface of the display panel 400. The lower protective film 500 may include a lower protective layer 510 and a third adhesive layer 520.

The lower protective layer 510 may serve to support the display panel 400 and protect the other surface of the display panel 400. In some embodiments, the lower protective layer 510 may be a plastic such as polyethylene terephthalate (PET) or polyimide.

The third adhesive layer 520 may be disposed on the lower protective layer 510. For example, the third adhesive layer 520 may be disposed between the lower protective layer 510 and the display panel 400. The lower protective layer 510 and the display panel 400 may be adhered to each other through the third adhesive layer 520. The third adhesive layer 520 may include a transparent adhesive such as a pressure sensitive adhesive (PSA) or an optically clear adhesive (OCA). Alternatively, the third adhesive layer 520 may include an acrylic adhesive material.

The third adhesive layer 520 may be handled in a state in which it is attached to the lower protective layer 510 in a process such as storage and transport of the lower protective film 500. Before the third adhesive layer 520 is attached to the display panel 400, a release film may be disposed on an upper surface of the third adhesive layer 520. The release film may be attached to the upper surface of the third adhesive layer 520 when the lower protective film 500 is handled, and may be removed when the third adhesive layer 520 is attached to the display panel 400.

The panel support layer 700 may be disposed below the lower protective film 500. The panel support layer 700 may be a rigid member whose shape or volume does not change easily due to an external pressure. Since the panel support layer 700 is disposed on the other surface of the display panel 400 and is the rigid member whose shape or volume does not change easily due to the external pressure, the panel support layer 700 may support the display panel 400.

In an embodiment, the panel support layer 700 may be a metal plate. For example, the panel support layer 700 is a metal plate, and may be made of a single metal or a metal alloy. The panel support layer 700 may include copper (Cu), aluminum (Al), stainless steel (SUS), and/or alloys thereof, but is not limited thereto.

In another embodiment, the panel support layer 700 may be made of a polymer including a carbon fiber or a glass fiber. The panel support layer 700 may have a structure in which polymers each including a carbon fibers or a glass fiber are stacked.

The panel support layer 700 may include a grating pattern disposed in the folding area FDA so as to be easily bent in the folding area FDA. The panel support layer 700 may include the grating pattern disposed in the folding area FDA, and may thus be easily bent when the display device 10 is folded.

The fourth adhesive layer 600 may be disposed on the panel support layer 700. For example, the fourth adhesive layer 600 may be disposed between the panel support layer 700 and the lower protective film 500. The panel support layer 700 and the lower protective film 500 may be adhered to each other through the fourth adhesive layer 600. The fourth adhesive layer 600 may include a transparent adhesive such as a pressure sensitive adhesive (PSA) or an optically clear adhesive (OCA). Alternatively, the fourth adhesive layer 600 may include an acrylic adhesive material.

The shielding film 800 may be disposed on the panel support layer 700. For example, the shielding film 800 may be disposed below the panel support layer 700. In some embodiments, the shielding film 800 may be a plating layer disposed on a rear surface (lower surface in FIG. 5) of the panel support layer 700. For example, the shielding film 800 may include copper (Cu), titanium (Ti), and/or alloys thereof.

The shielding film 800 may be formed on the rear surface of the panel support layer 700 by chemical vapor deposition (CVD) such as thermal chemical vapor deposition (TCVD), plasma-enhanced chemical vapor deposition (PECVD), or atmospheric pressure chemical vapor deposition (APCVD) or physical vapor deposition (PVD) such as thermal evaporation, sputtering, or e-beam evaporation. Preferably, the shielding film 800 may be formed by the physical vapor deposition.

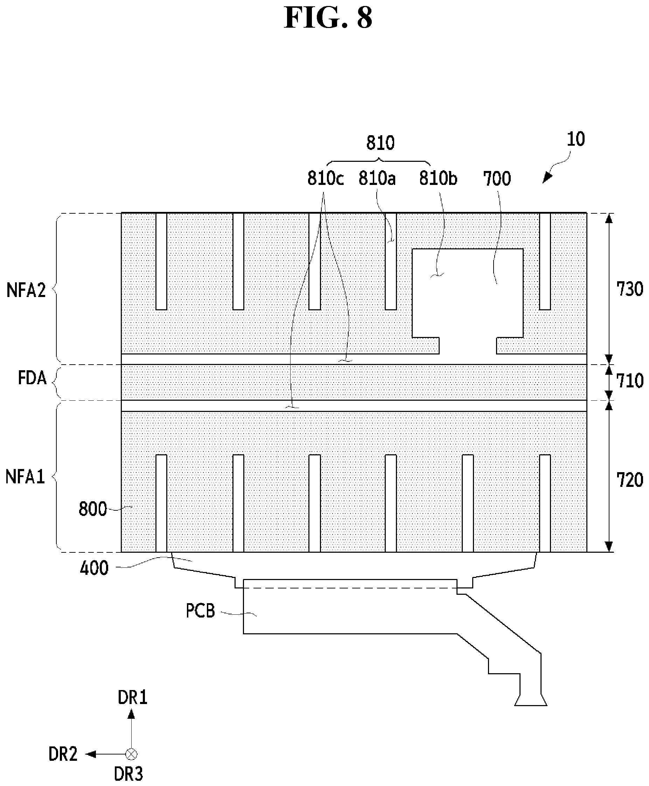

The shielding film 800 may perform an electromagnetic wave shielding function and a heat dissipation function. For example, the shielding film 800 may prevent an electromagnetic wave generated from various electronic components mounted on a printed circuit board PCB (see FIG. 8), an external electronic device, or the like, to be described later from permeating into the display panel 400. In addition, the shielding film 800 may dissipate heat generated from the electronic components or the display panel 400 to the outside by including a removal area 810 (see FIG. 8) to be described later.

In some embodiments, a thickness TH_800 of the shielding film 800 (length of the shielding film 800 in the third direction DR3) may be approximately 1 micrometer (µm) to 5 µm, but is not limited thereto. In the display device 10 according to the present embodiment, by directly forming the shielding film 800 having a small thickness on the rear surface of the panel support layer 700 through the deposition, it is possible to reduce a thickness of the display device 10 and improve the foldability of the display device 10, compared to a case where a shielding material is attached using a separate adhesive member.

FIG. 6 is a cross-sectional view illustrating an example of a display panel according to an embodiment.

Referring to FIG. 6, the display panel 400 may include a substrate SUB, a display layer DISL, and a touch sensor layer ISP. The display layer DISL may include a thin film transistor layer TFTL, a light emitting element layer EML, and an encapsulation layer TFEL.

The substrate SUB may be made of an insulating material such as a polymer resin. For example, the substrate SUB may be made of polyimide. The substrate SUB may be a flexible substrate that may be bent, folded, and rolled.

The thin film transistor layer TFTL may be disposed on the substrate SUB. The thin film transistor layer TFTL may include a barrier film BR, thin film transistors TFT1, first capacitor electrodes CAE1, second capacitor electrodes CAE2, first anode connection electrodes ANDE1, second anode connection electrodes ANDE2, a gate insulating film 130, a first interlayer insulating film 141, a second interlayer insulating film 142, a first planarization film 160, and a second planarization film 180.

The barrier film BR may be disposed on the substrate SUB. The barrier film BR is a film for protecting thin film transistors of the thin film transistor layer TFTL and light emitting layers 172 of the light emitting element layer EML from moisture permeating through the substrate SUB vulnerable to moisture permeation. The barrier film BR may include a plurality of inorganic films that are alternately stacked. For example, the barrier film BR may be formed as multiple films in which one or more inorganic films of a silicon nitride layer, a silicon oxynitride layer, a silicon oxide layer, a titanium oxide layer, and an aluminum oxide layer are alternately stacked.

The thin film transistors TFT1 may be disposed on the barrier film BR. Active layers ACT1 of the thin film transistors TFT1 may be disposed on the barrier film BR. The active layer ACT1 of the thin film transistor TFT1 may include polycrystalline silicon, single crystal silicon, low-temperature polycrystalline silicon, amorphous silicon, or an oxide semiconductor.

The active layer ACT1 may include a channel region CHA1, a source region TS1, and a drain region TD1. The channel region CHA1 may be a region overlapping a gate electrode TG1 in the third direction DR3, which is a thickness direction of the substrate SUB. The source region TS1 may be disposed on one side of the channel region CHA1, and the drain region TD1 may be disposed on the other side of the channel region CHA1. The source region TS1 and the drain region TD1 may be regions that do not overlap the gate electrode TG1 in the third direction DR3. The source region TS1 and the drain region TD1 may be regions having conductivity by doping a silicon semiconductor or an oxide semiconductor with ions or impurities.

The gate insulating film 130 may be disposed on the active layer ACT1 of the thin film transistor TFT1. The gate insulating film 130 may be formed as an inorganic film such as a silicon nitride layer, a silicon oxynitride layer, a silicon oxide layer, a titanium oxide layer, or an aluminum oxide layer.

The gate electrodes TG1 of the thin film transistors TFT1 and the first capacitor electrodes CAE1 may be disposed on the gate insulating film 130. The gate electrode TG1 may overlap the channel region CHA1 in the third direction DR3. It has been illustrated in FIG. 6 that the gate electrode TG1 and the first capacitor electrode CAE1 are disposed to be spaced apart from each other, but the gate electrode TG1 and the first capacitor electrode CAE1 may also be connected to and formed integrally with each other. Each of the gate electrode TG1 and the first capacitor electrode CAE1 may be formed as a single layer or multiple layers made of any one of molybdenum (Mo), aluminum (Al), chromium (Cr), gold (Au), titanium (Ti), nickel (Ni), neodymium (Nd), and copper (Cu), or alloys thereof.

The first interlayer insulating film 141 may be disposed on the gate electrodes TG1 of the thin film transistors TFT1 and the first capacitor electrodes CAE1. The first interlayer insulating film 141 may be formed as an inorganic film such as a silicon nitride layer, a silicon oxynitride layer, a silicon oxide layer, a titanium oxide layer, or an aluminum oxide layer. The first interlayer insulating film 141 may be formed as a plurality of inorganic films.

The second capacitor electrodes CAE2 may be disposed on the first interlayer insulating film 141. The second capacitor electrode CAE2 may overlap the first capacitor electrode CAE1 in the third direction DR3. In addition, when the gate electrode TG1 and the first capacitor electrode CAE1 are formed integrally with each other, the second capacitor electrode CAE2 may overlap the gate electrode TG1 in the third direction DR3. Since the first interlayer insulating film 141 has a predetermined dielectric constant, a capacitor may be formed by the first capacitor electrode CAE1, the second capacitor electrode CAE2, and the first interlayer insulating film 141 disposed between the first capacitor electrode CAE1 and the second capacitor electrode CAE2. The second capacitor electrode CAE2 may be formed as a single layer or multiple layers made of any one of molybdenum (Mo), aluminum (Al), chromium (Cr), gold (Au), titanium (Ti), nickel (Ni), neodymium (Nd), and copper (Cu), or alloys thereof.

The second interlayer insulating film 142 may be disposed on the second capacitor electrodes CAE2. The second interlayer insulating film 142 may be formed as an inorganic film such as a silicon nitride layer, a silicon oxynitride layer, a silicon oxide layer, a titanium oxide layer, or an aluminum oxide layer. The second interlayer insulating film 142 may be formed as a plurality of inorganic films.

The first interlayer insulating film 141 and the second interlayer insulating film 142 may be included in an interlayer insulating film 140.

The first anode connection electrodes ANDE1 may be disposed on the second interlayer insulating film 142. The first anode connection electrode ANDE1 may be connected to the drain region TD1 of the thin film transistor TFT1 through a first connection contact hole ANCT1 penetrating through the gate insulating film 130, the first interlayer insulating film 141, and the second interlayer insulating film 142. The first anode connection electrode ANDE1 may be formed as a single layer or multiple layers made of any one of molybdenum (Mo), aluminum (Al), chromium (Cr), gold (Au), titanium (Ti), nickel (Ni), neodymium (Nd), and copper (Cu), or alloys thereof.

The first planarization film 160 for planarizing a step due to the thin film transistors TFT1 may be disposed on the first anode connection electrodes ANDE1. The first planarization film 160 may be formed as an organic film made of an acrylic resin, an epoxy resin, a phenolic resin, a polyamide resin, a polyimide resin, or the like.

The second anode connection electrodes ANDE2 may be disposed on the first planarization film 160. The second anode connection electrode ANDE2 may be connected to the first anode connection electrode ANDE1 through a second connection contact hole ANCT2 penetrating through the first planarization film 160. The second anode connection electrode ANDE2 may be formed as a single layer or multiple layers made of any one of molybdenum (Mo), aluminum (Al), chromium (Cr), gold (Au), titanium (Ti), nickel (Ni), neodymium (Nd), and copper (Cu), or alloys thereof.

The second planarization film 180 may be disposed on the second anode connection electrodes ANDE2. The second planarization film 180 may be formed as an organic film made of an acrylic resin, an epoxy resin, a phenolic resin, a polyamide resin, a polyimide resin, or the like.

The light emitting element layer EML including light emitting elements LEL and a bank 190 may be disposed on the second planarization film 180. Each of the light emitting elements LEL includes a pixel electrode 171, a light emitting layer 172, and a common electrode 173.

The pixel electrode 171 may be disposed on the second planarization film 180. The pixel electrode 171 may be connected to the second anode connection electrode ANDE2 through a third connection contact hole ANCT3 penetrating through the second planarization film 180.

In a top emission structure in which light is emitted toward the common electrode 173 based on the light emitting layer 172, the pixel electrode 171 may be made of a metal material having high reflectivity, such as a stacked structure (Ti/Al/Ti) of aluminum (Al) and titanium (Ti), a stacked structure (ITO/Al/ITO) of aluminum (Al) and indium tin oxide (ITO), a stacked structure (ITO/Ag/ITO) of silver (Ag) and ITO, an APC alloy, and a stacked structure (ITO/APC/ITO) of an APC alloy and ITO. The APC alloy is an alloy of silver (Ag), palladium (Pd), and copper (Cu).

The bank 190 may be formed to partition the pixel electrodes 171 on the second planarization film 180 in order to define a first light emitting portion EA1 and a second light emitting portion EA2. The bank 190 may be disposed to cover edges of the pixel electrode 171. The bank 190 may be formed as an organic film made of an acrylic resin, an epoxy resin, a phenolic resin, a polyamide resin, a polyimide resin, or the like.

Each of the first light emitting portion EA1 and the second light emitting portion EA2 refers to each area where the pixel electrode 171, the light emitting layer 172, and the common electrode 173 are sequentially stacked and holes from the pixel electrode 171 and electrons from the common electrode 173 are recombined with each other in the light emitting layer 172 to emit light.

The light emitting layer 172 may be disposed on the pixel electrode 171 and the bank 190. The light emitting layer 172 may include an organic material to emit light of a predetermined color. For example, the light emitting layer 172 may include a hole transporting layer, an organic material layer, and an electron transporting layer.

The common electrode 173 may be disposed on the light emitting layer 172. The common electrode 173 may be disposed to cover the light emitting layer 172. The common electrode 173 may be a common layer formed in common in the first light emitting portion EA1 and the second light emitting portion EA2.

In the top emission structure, the common electrode 173 may be made of a transparent conductive material (TCO) such as ITO or indium zinc oxide (IZO) capable of transmitting light therethrough or a semi-transmissive conductive material such as magnesium (Mg), silver (Ag), or an alloy of magnesium (Mg) and silver (Ag). When the common electrode 173 is made of the semi-transmissive conductive material, light emission efficiency may be increased by a micro cavity.

A spacer 191 may be disposed on the bank 190. The spacer 191 may serve to support a mask during a manufacturing process of manufacturing the light emitting layer 172. The spacer 191 may be formed as an organic film made of an acrylic resin, an epoxy resin, a phenolic resin, a polyamide resin, a polyimide resin, or the like.

In some embodiments, the display panel 400 may further include a capping layer CPL disposed on the common electrode 173. The capping layer CPL may include an inorganic material. For example, the capping layer CPL may include at least one of silicon nitride, aluminum nitride, zirconium nitride, titanium nitride, hafnium nitride, tantalum nitride, silicon oxide, aluminum oxide, titanium oxide, tin oxide, cerium oxide, and silicon oxynitride.

The encapsulation layer TFEL may be disposed on the common electrode 173. The encapsulation layer TFEL may include at least one inorganic film in order to prevent oxygen or moisture from permeating into the light emitting element layer EML. In addition, the encapsulation layer TFEL may include at least one organic film in order to protect the light emitting element layer EML from foreign substances such as dust. For example, the encapsulation layer TFEL may include a first encapsulation inorganic film TFE1, an encapsulation organic film TFE2, and a second encapsulation inorganic film TFE3.

The first encapsulation inorganic film TFE1 may be disposed on the common electrode 173, the encapsulation organic film TFE2 may be disposed on the first encapsulation inorganic film TFE1, and the second encapsulation inorganic film TFE3 may be disposed on the encapsulation organic film TFE2. Each of the first encapsulation inorganic film TFE1 and the second encapsulation inorganic film TFE3 may be formed as multiple films in which one or more inorganic films of a silicon nitride layer, a silicon oxynitride layer, a silicon oxide layer, a titanium oxide layer, and an aluminum oxide layer are alternately stacked. The encapsulation organic film TFE2 may be an organic film made of an acrylic resin, an epoxy resin, a phenolic resin, a polyamide resin, a polyimide resin, or the like.

The touch sensor layer ISP may be disposed on the encapsulation layer TFEL. The touch sensor layer ISP may be mounted in the display panel 400 through a continuous process. The touch sensor layer ISP may include a first touch insulating film TINS1, a first conductive layer ICL1, a second touch insulating film TINS2, a second conductive layer ICL2, and a third touch insulating film TINS3.

The first touch insulating film TINS1 may be disposed on the encapsulation layer TFEL. The first touch insulating film TINS1 may be formed as an inorganic film such as a silicon nitride layer, a silicon oxynitride layer, a silicon oxide layer, a titanium oxide layer, or an aluminum oxide layer.

The first conductive layer ICL1 may be disposed on the first touch insulating film TINS1. The first conductive layer ICL1 may be formed as a single layer or multiple layers made of any one of molybdenum (Mo), aluminum (Al), chromium (Cr), gold (Au), titanium (Ti), nickel (Ni), neodymium (Nd), and copper (Cu), or alloys thereof.

The second touch insulating film TINS2 may be disposed on the first conductive layer ICL1. The second touch insulating film TINS2 may be formed as an inorganic film such as a silicon nitride layer, a silicon oxynitride layer, a silicon oxide layer, a titanium oxide layer, or an aluminum oxide layer. Alternatively, the second touch insulating film TINS2 may be formed as an organic film made of an acrylic resin, an epoxy resin, a phenolic resin, a polyamide resin, a polyimide resin, or the like.

The second conductive layer ICL2 may be disposed on the second touch insulating film TINS2. The second conductive layer ICL2 may be formed as a single layer or multiple layers made of any one of molybdenum (Mo), aluminum (Al), chromium (Cr), gold (Au), titanium (Ti), nickel (Ni), neodymium (Nd), and copper (Cu), or alloys thereof.

The third touch insulating film TINS3 may be formed on the second conductive layer ICL2. The third touch insulating film TINS3 may serve to planarize a step formed due to electrodes of the second conductive layer ICL2. The third touch insulating film TINS3 may be formed as an organic film made of an acrylic resin, an epoxy resin, a phenolic resin, a polyamide resin, a polyimide resin, or the like.

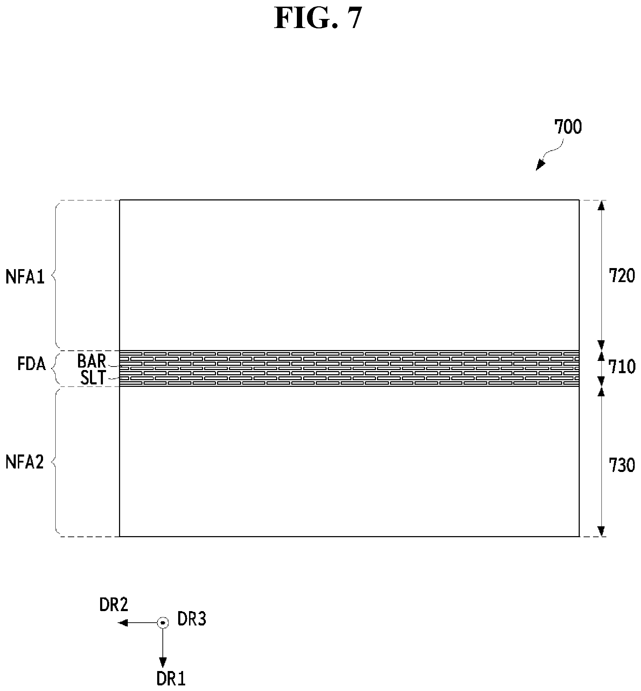

FIG. 7 is a plan view illustrating a panel support layer according to an embodiment.

Referring to FIG. 7, the panel support layer 700 may include a folding portion 710, a first non-folding portion 720, and a second non-folding portion 730. The folding portion 710 may be disposed in the folding area FDA, the first non-folding portion 720 may be disposed in the first non-folding area NFA1, and the second non-folding portion 730 may be disposed in the second non-folding area NFA2.

The first non-folding portion 720 and the second non-folding portion 730 may be portions that are not folded when the display device 10 is folded. The first non-folding portion 720 may be disposed on the other side of the folding portion 710 in the first direction DR1, and the second non-folding portion 730 may be disposed on one side of the folding portion 710 in the first direction DR1.

The folding portion 710 may be a portion that is folded when the display device 10 is folded. The folding portion 710 may be disposed between the first non-folding portion 720 and the second non-folding portion 730 in the first direction DR1.

The folding portion 710 may include a grating pattern. For example, the folding portion 710 may include a plurality of bars BAR and a plurality of slits SLT disposed between the plurality of bars BAR. Each of the plurality of slits SLT may be a hole penetrating through the panel support layer 700 in the third direction DR3.

Each of the plurality of slits SLT may extend in the second direction DR2. For example, a length of each of the plurality of slits SLT in the second direction DR2 may be greater than a length of each of the plurality of slits SLT in the first direction DR1.

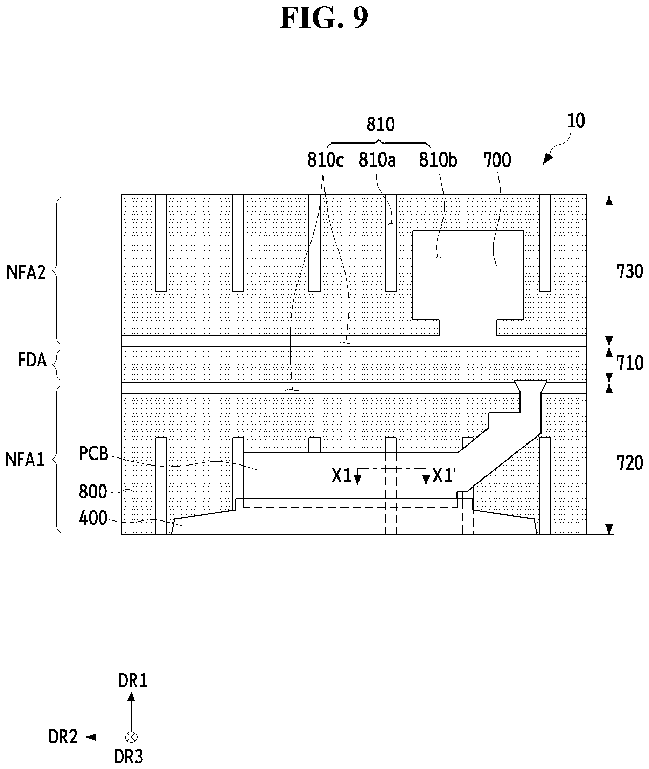

FIG. 8 is a rear view illustrating the display device according to an embodiment. FIG. 9 is a rear view illustrating a state in which the display device of FIG. 8 is bent.

Referring to FIGS. 8 and 9 in addition to FIG. 5, the display panel 400 of the display device 10 may be disposed on a front surface (upper surface in FIG. 5) of the panel support layer 700. As illustrated in FIG. 8, the display panel 400 may include a sub-area protruding from the panel support layer 700. As illustrated in FIG. 9, the sub-area of the display panel 400 may be bent to be positioned on the rear surface (lower surface in FIG. 5) of the panel support layer 700. Pads to which a printed circuit board PCB to be described later may be coupled may be disposed in the sub-area.

The display device 10 may further include a printed circuit board PCB. The printed circuit board PCB may be disposed on the sub-area of the display panel 400. For example, the printed circuit board PCB may be coupled to the pads. The printed circuit board PCB may be attached to the pads using a conductive adhesive member such as an anisotropic conductive film and an anisotropic conductive adhesive. Accordingly, the printed circuit board PCB may be electrically connected to signal lines of the display panel 400. In some embodiments, the printed circuit board PCB may be a flexible printed circuit board or a flexible film such as a chip on film.

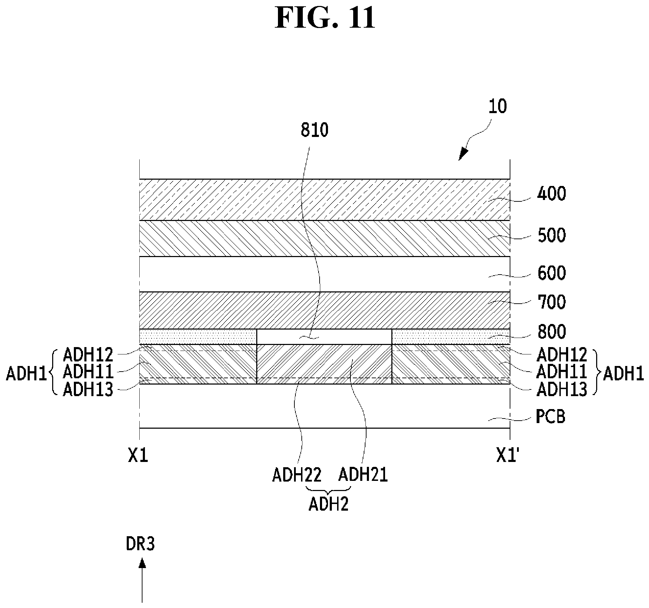

As illustrated in FIG. 9, when a sub-area of the display device 10 is bent, the printed circuit board PCB may be disposed on the rear surface of the panel support layer 700. Adhesive members ADH1 and ADH2 (see FIG. 11) may be disposed between the printed circuit board PCB and the rear surface of the panel support layer 700 in order to fix the printed circuit board PCB onto the rear surface of the panel support layer 700. When a shielding film 800 to be described later is disposed on the rear surface of the panel support layer 700, the adhesive members ADH1 and ADH2 (see FIG. 11) may be disposed on a rear surface (lower surface in FIG. 5) of the shielding film 800. Cross-sectional structures of the panel support layer 700, the shielding film 800, and the adhesive members ADH1 and ADH2 (see FIG. 11) will be described later with reference to FIG. 11.

The display device 10 according to the present embodiment may include a shielding film 800 disposed on the rear surface of the panel support layer 700. The shielding film 800 may be entirely disposed on the rear surface of the panel support layer 700, and may include a removal area 810 in at least a portion thereof. The removal area 810 may be an opening exposing the rear surface of the panel support layer 700. The removal area 810 may provide a heat circulation space (or passage) so that heat generated from an electronic component disposed on the rear surface of the panel support layer 700 or the display panel 400 may be dissipated to the outside.

The term 'removal' as used herein includes not only a case where any one component disappears after being formed, but also a case where any one component is not disposed from the beginning. For example, in the present specification, the removal area 810 of the shielding film 800 may refer to an area where the shielding film 800 is removed after being entirely formed on the rear surface of the panel support layer 700 or may refer to an area where the shielding film 800 is not disposed from the beginning because the shielding film 800 was formed only in the remaining portion excluding a corresponding area when the shielding film 800 was first formed.

The removal area 810 of the shielding film 800 may include a first removal area 810a, a second removal area 810b, and a third removal area 810c.

The first removal area 810a may be disposed on the first non-folded portion 720 and the second non-folded portion 730. In an embodiment, the first removal area 810a may extend in the first direction DR1. In some embodiments, the number of first removal areas 810a may be plural. In this case, the first removal areas 810a may be disposed to be spaced apart from each other in the second direction DR2.

At least one end of the first removal area 810a may expose at least one side of the first non-folded portion 720 or at least one side of the second non-folded portion 730. For example, one end of the first removal area 810a disposed on the first non-folding portion 720 may be in contact with one side of the first non-folding portion 720 in the first direction DR1, and one end of the first removal area 810a disposed on the second non-folding portion 730 may be in contact with the other side of the second non-folding portion 730 in the first direction DR1.

In an embodiment, a length of the first removal area 810a in the first direction DR1 may be smaller than a length of the first non-folding portion 720 in the first direction DR1 and a length of the second non-folding portion 730 in the first direction DR1. The other end of the first removal area 810a disposed on the first non-folding portion 720 may be spaced apart from a boundary between the first non-folding portion 720 and the folding portion 710 in the first direction DR1, and the other end of the first removal area 810a disposed on the second non-folding portion 730 may be spaced apart from a boundary between the second non-folding portion 730 and the folding portion 710 in the first direction DR1. Likewise, the other end of the first removal area 810a may be spaced apart from a third removal area 810c to be described later in the first direction DR1.

The second removal area 810b may be disposed on at least one of the first non-folding portion 720 and the second non-folding portion 730. For example, as illustrated in FIGS. 8 and 9, the second removal area 810b may be disposed on the second non-folding portion 730. The second removal area 810b may be a heat circulation space for dissipating heat generated from various electronic components disposed on the rear surface of the panel support layer 700 to the outside.

In some embodiments, the second removal area 810b may be connected to the third removal area 810c. As illustrated in FIGS. 8 and 9, a connection portion may be disposed between the second removal area 810b and the third removal area 810c. It has been illustrated in FIGS. 8 and 9 that the second removal area 810b has a substantially rectangular shape, but the present invention is not limited thereto.

The third removal area 810c may be disposed on at least one side of the folding portion 710. For example, the third removal areas 810c may be disposed on one side and the other side of the folding portion 710. The third removal areas 810c may be disposed between the first non-folding portion 720 and the folding portion 710 and between the second non-folding portion 730 and the folding portion 710, respectively. The third removal area 810c may extend in the second direction DR2. In some embodiments, the third removal area 810c may extend without being disconnected from one side of the panel support layer 700 in the second direction DR2 to the other side of the panel support layer 700 in the second direction DR2.

In some embodiments, the shielding film 800 may not include at least one of the second removal area 810b and the third removal area 810c. As an example, the second removal area 810b may be omitted depending on a size, a position, and the like, of the electronic component disposed on the rear surface of the panel support layer 700. As another example, the third removal area 810c may be omitted depending on folding characteristics of the display device 10.

In some embodiments, a total area of the removal area 810 may be 5% to 25% of a total area of the rear surface of the panel support layer 700. When the total area of the removal area 810 is 5% or more of the total area of the rear surface of the panel support layer 700, the heat circulation space may be effectively secured. When the total area of the removal area 810 is 25% or less of the total area of the rear surface of the panel support layer 700, the electromagnetic wave generated from various electronic components mounted on the printed circuit board PCB, the external electronic device, or the like, may be effectively shielded.

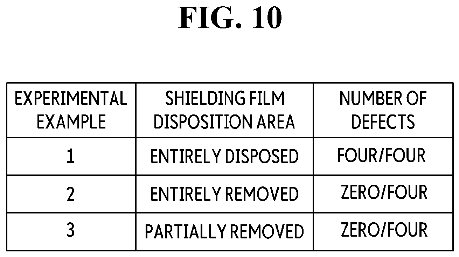

FIG. 10 is a table illustrating results of a reliability test of the display device according to a degree of disposition and removal of a shielding film according to an embodiment.

Referring to FIG. 10 in addition to FIGS. 8 and 9, a first experimental example is an experimental example in which the shielding film 800 is entirely disposed on the rear surface of the panel support layer 700. That is, the first experimental example is an experimental example in which the shielding film 800 does not include the removal area. A second experimental example is an experimental example in which the shielding film 800 itself is not disposed on the rear surface of the panel support layer 700. A third experimental example is an experimental example in which the shielding film 800 is entirely disposed on the rear surface of the panel support layer 700, but is partially removed. The shielding film 800 of the third experimental example may be the same as the shielding film 800 of the display device 10 according to an embodiment described with reference to FIG. 8 and the like.

A 'defect' illustrated in the table of FIG. 10 means that bubbles were generated in the adhesive members ADH1 and ADH2 (see FIG. 11) disposed between the panel support layer 700 and the printed circuit board PCB when a sample was left for 200 hours or more under conditions of a temperature of 85°C and an absolute humidity of 85%.

As illustrated in the table of FIG. 10, in the first experimental example, the shielding film 800 was entirely disposed on the rear surface of the panel support layer 700 without the removal area 810, and accordingly, the heat circulation space was not secured, such that defects occurred in all of four samples.

In the second experimental example, the shielding film 800 was not disposed, and accordingly, heat dispersion was not hindered, such that a defect did not occur in any of four samples.

In the third experimental example, the shielding film 800 included the removal area 810 and was partially removed on the rear surface of the panel support layer 700, and accordingly, the heat circulation space was secured, such that a defect did not occur in any of four samples.

In the display device 10 according to the present embodiment, by disposing the shielding film 800, it is possible to prevent the electromagnetic wave generated from various electronic components mounted on the printed circuit board PCB, the external electronic device, or the like, from permeating into the display panel 400. In addition, as in the third experimental example, the shielding film 800 includes the removal area 810, and accordingly, the heat circulation space is secured, such that a defect such as the generation of bubbles in the adhesive member may be minimized.

FIG. 11 is a schematic cross-sectional view illustrating an example of the display device taken along line X1-X1' of FIG. 9.

Referring to FIG. 11 in addition to FIGS. 8 and 9, the shielding film 800 may be disposed on the rear surface of the panel support layer 700. The printed circuit board PCB may be disposed on the rear surface (lower surface in FIG. 5) of the shielding film 800.

The display device 10 may further include adhesive members ADH1 and ADH2 disposed between the shielding film 800 and the printed circuit board PCB. The adhesive members ADH1 and ADH2 may include a first adhesive member ADH1 and a second adhesive member ADH2.

The first adhesive member ADH1 may be disposed on an area other than the removal area 810 of the shielding film 800. The first adhesive member ADH1 may not overlap the removal area 810 in the third direction DR3. The first adhesive member ADH1 may be in direct contact with the shielding film 800.

The second adhesive member ADH2 may be disposed on the removal area 810 of the shielding film 800. The second adhesive member ADH2 may overlap the removal area 810 of the shielding film 800 in the third direction DR3. The second adhesive member ADH2 may not be in contact with the shielding film 800. The second adhesive member ADH2 may be spaced apart from the panel support layer 700 in the third direction DR3 with the removal area 810 interposed therebetween. Accordingly, the heat circulation space is secured by the removal area 810, such that heat dissipation characteristics of the display device 10 may be improved.

In the display device 10 according to the present embodiment, the first adhesive member ADH1 may be a double-sided attachment type, and the second adhesive member ADH2 may be a single-sided attachment type. For example, the first adhesive member ADH1 may include a first adhesive support layer ADH11 and a first adhesive material layer ADH12 and a second adhesive material layer ADH13 respectively disposed on both surfaces of the first adhesive support layer ADH11. The second adhesive member ADH2 may include a second adhesive support layer ADH21 and a third adhesive material layer ADH22 disposed on a rear surface (lower surface in FIG. 11) of the second adhesive support layer ADH21.

In an area that does not overlap the removal area 810 of the shielding film 800, the shielding film 800 and the printed circuit board PCB may be attached to the first adhesive material layer ADH12 and the second adhesive material layer ADH13, respectively. In an area that overlaps the removal area 810 of the shielding film 800, the printed circuit board PCB may be attached to the third adhesive material layer ADH3.

The display device 10 according to the present embodiment includes the second adhesive member ADH2 of the single-sided attachment type, such that the second adhesive member ADH2 may be spaced apart from the panel support layer 700 in the third direction DR3 with the removal area 810 interposed therebetween. Accordingly, the heat circulation space is secured, such that the heat dissipation characteristics of the display device 10 may be improved.

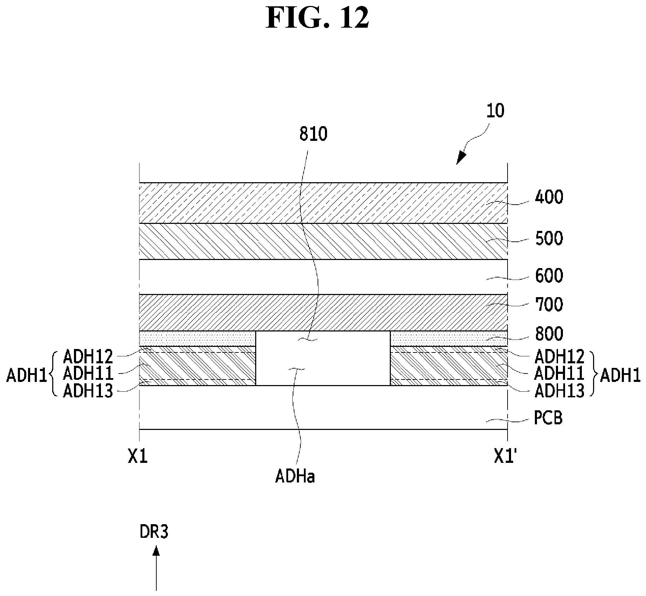

FIG. 12 is a schematic cross-sectional view illustrating another example of the display device taken along line X1-X1' of FIG. 9.

Referring to FIG. 12 in addition to FIG. 11, the adhesive members ADH1 and ADH2 may not include the second adhesive member ADH2. For example, in the area that overlaps the removal area 810 of the shielding film 800, the adhesive members ADH1 and ADH2 themselves may not be disposed. In this case, the adhesive members ADH1 and ADH2 may include an adhesive removal area ADHa instead of the second adhesive member ADH2. Accordingly, the heat circulation space is further secured by a volume of the adhesive removal area ADHa, such that the heat dissipation characteristics of the display device 10 may be further improved.

Hereinafter, other embodiments of the display device according to an embodiment will be described. In the following embodiments, the same components as those of the above-described embodiment will be denoted by the same reference numerals, and an overlapping description thereof will be omitted or simplified and contents different from those described above will be mainly described.

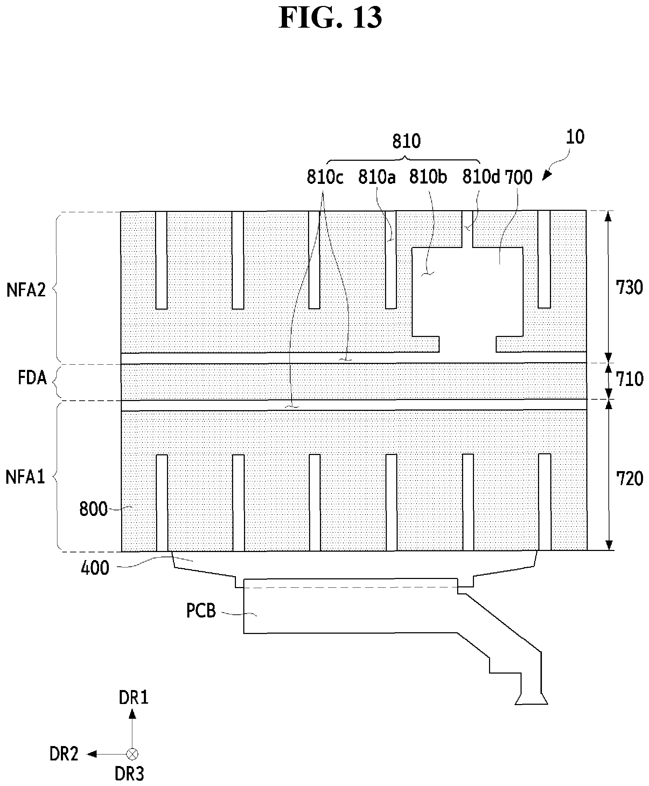

FIG. 13 is a rear view illustrating a display device according to another embodiment.

Referring to FIG. 13, the shielding film 800 may further include a fourth removal area 810d. The fourth removal area 810d may be disposed on the second non-folding portion 730. The fourth removal area 810d may be disposed on one side of the third removal area 810c (e.g., one side of the third removal area 810c in the first direction DR1). The fourth removal area 810d may be disposed between the first removal areas 810a in the second direction DR2. The fourth removal area 810d may extend in the first direction DR1.

The fourth removal area 810d may be connected to the second removal area 810b. The fourth removal area 810d may connect the second removal area 810b and one side of the second non-folding portion 730 in the first direction DR1 to each other in a plan view.

The display device 10 according to the present embodiment may effectively dissipate heat generated from an electronic component disposed adjacent to the second removal area 810b to the outside by including the fourth removal area 810d.

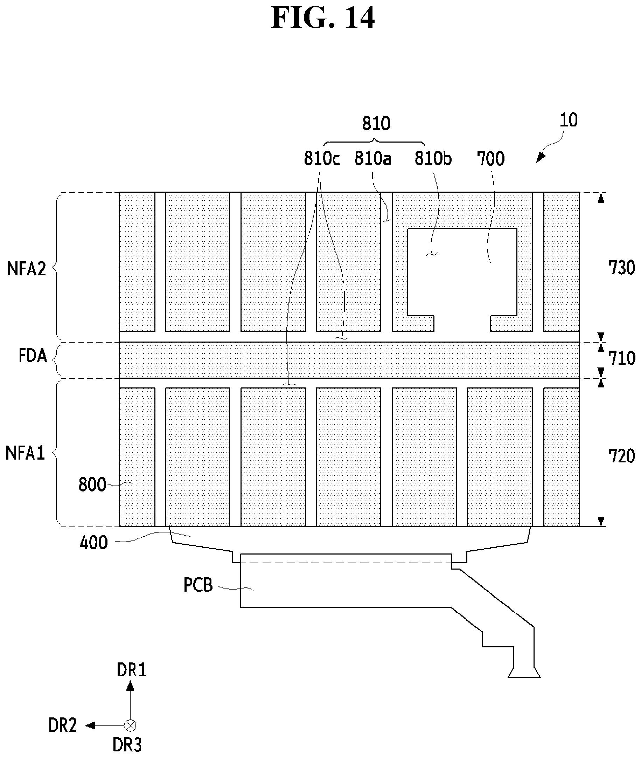

FIG. 14 is a rear view illustrating a display device according to still another embodiment.

Referring to FIG. 14, the first removal area 810a may extend in the first direction DR1 to be connected to the third removal area 810c. The first removal area 810a disposed on the first non-folding portion 720 may connect the third removal area 810c and one side of the first non-folding portion 720 in the first direction DR1 to each other in a plan view. The first removal area 810a disposed on the second non-folding portion 730 may connect the third removal area 810c and the other side of the second non-folding portion 730 in the first direction DR1 to each other in a plan view.

Accordingly, the display device 10 according to the present embodiment may prevent heat from being trapped at the boundary between the first non-folding portion 720 and the folding portion 710 and the boundary between the second non-folding portion 730 and the folding portion 710 when the display device 10 is folded, and may effectively dissipate the heat to the outside.

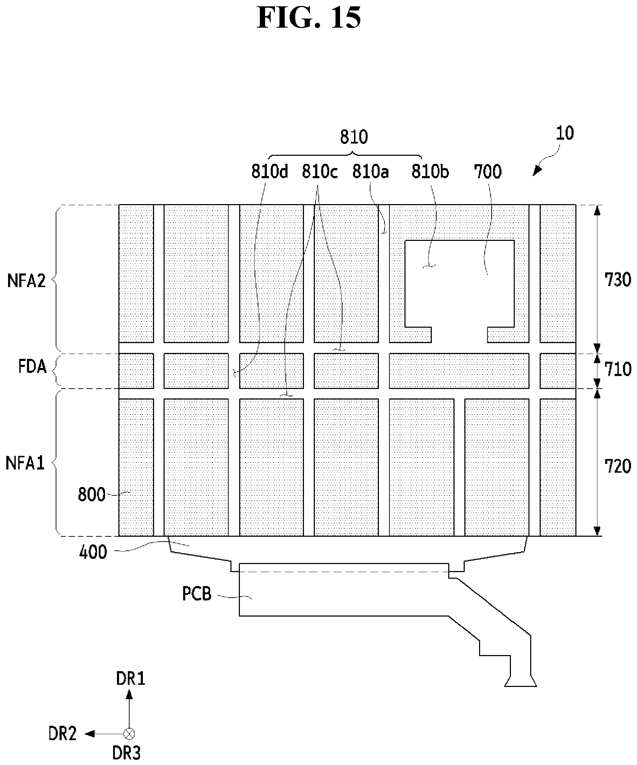

FIG. 15 is a rear view illustrating a display device according to still another embodiment.

Referring to FIG. 15, the shielding film 800 may further include a fourth removal area 810d. The fourth removal area 810d may be disposed on the folding portion 710. The fourth removal area 810d may be disposed between the third removal areas 810c. For example, the fourth removal area 810d may be disposed between the third removal area 810c adjacent to the boundary between the first non-folding portion 720 and the folding portion 710 and the third removal area 810c adjacent to the boundary between the second non-folding portion 730 and the folding portion 710.

The fourth removal area 810d may be connected to the third removal area 810c. The fourth removal area 810d may connect the third removal area 810c adjacent to the boundary between the first non-folding portion 720 and the folding portion 710 and the third removal area 810c adjacent to the boundary between the second non-folding portion 730 and the folding portion 710 to each other.

In some embodiments, the fourth removal area 810d may be positioned at the same point as the first removal area 810a in the second direction DR2. The fourth removal area 810d may be connected to the first removal area 810a in the first direction DR1.

Accordingly, the display device 10 according to the present embodiment may effectively dissipate heat generated in the folding portion 710 to the outside.

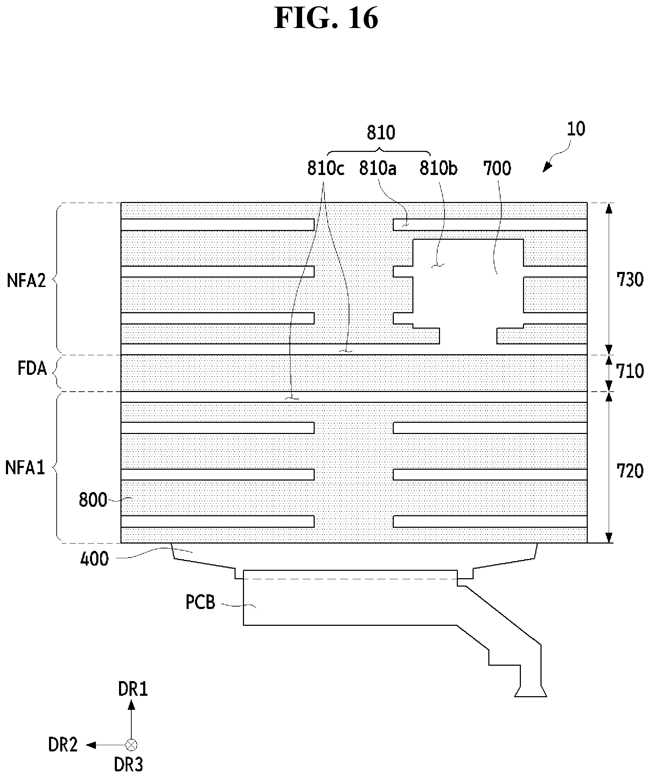

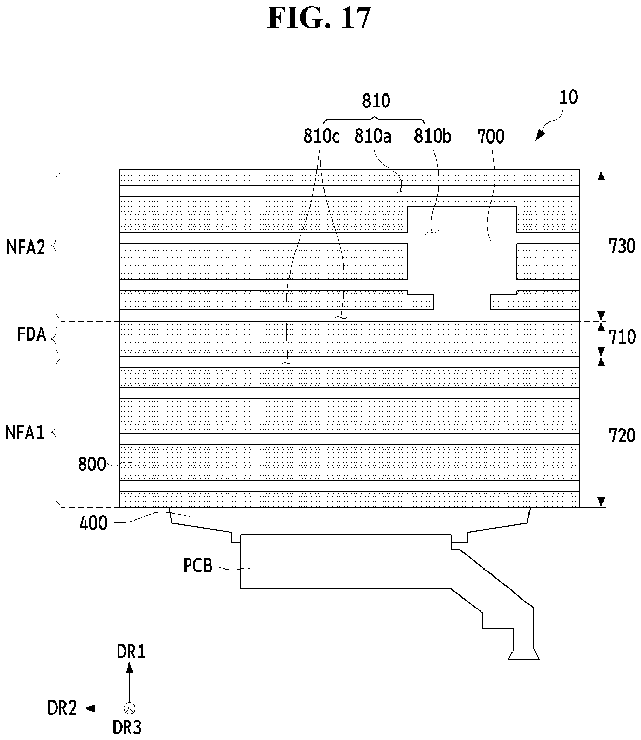

FIG. 16 is a rear view illustrating a display device according to still another embodiment. FIG. 17 is a rear view illustrating a display device according to still another embodiment.

Referring to FIGS. 16 and 17, the first removal area 810a may extend in the second direction DR2. When the number of first removal areas 810a is plural, the first removal areas 810a may be disposed to be spaced apart from each other in the first direction DR1.

At least one end of the first removal area 810a may expose at least one side of the panel support layer 700. For example, one end of the first removal area 810a may be in contact with one side or the other side of the panel support layer 700 in the second direction DR2.

In an embodiment, as illustrated in FIG. 16, a length of the first removal area 810a in the second direction DR2 may be smaller than a length of the panel support layer 700 in the second direction DR2. The other end of the first removal area 810a disposed adjacent to one side of the panel support layer 700 the second direction DR2 and the other end of the first removal area 810a disposed adjacent to the other side of the panel support layer 700 in the second direction DR2 may face each other and may be spaced apart from each other.

In another embodiment, as illustrated in FIG. 17, a length of the first removal area 810a in the second direction DR2 may be the same as a length of the panel support layer 700 in the second direction DR2. The first removal area 810a may extend without being disconnected from one side of the panel support layer 700 in the second direction DR2 to the other side of the panel support layer 700 in the second direction DR2.

In some embodiments, the first removal area 810a may penetrate through the second removal area 810b in the second direction DR2.

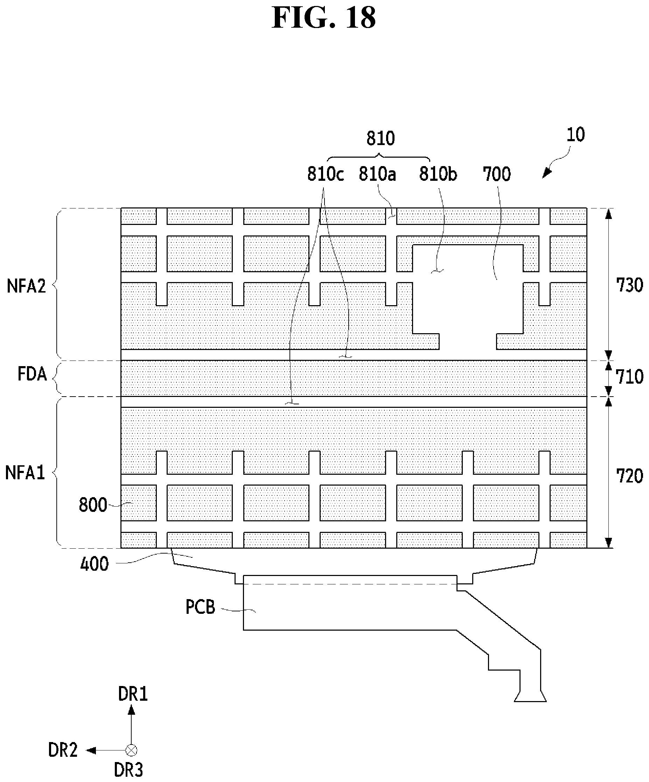

FIG. 18 is a rear view illustrating a display device according to still another embodiment.

Referring to FIG. 18, the first removal area 810a may extend in the first direction DR1 and the second direction DR2. The first removal area 810a may have a grating shape.

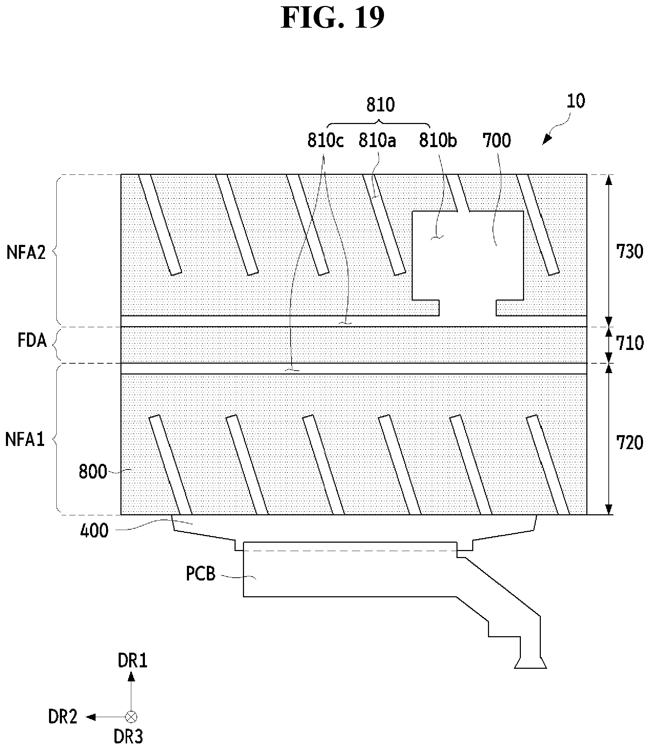

FIG. 19 is a rear view illustrating a display device according to still another embodiment.

Referring to FIG. 19, the first removal area 810a may extend in a diagonal direction defined by the first direction DR1 and the second direction DR2. However, the present invention is not limited thereto, and the first removal area 810a may also extend in a diagonal direction defined by directions opposite to the first direction DR1 and the second direction DR2. Angles formed by the diagonal line and each of the first direction DR1 and the second direction DR2 are not limited.

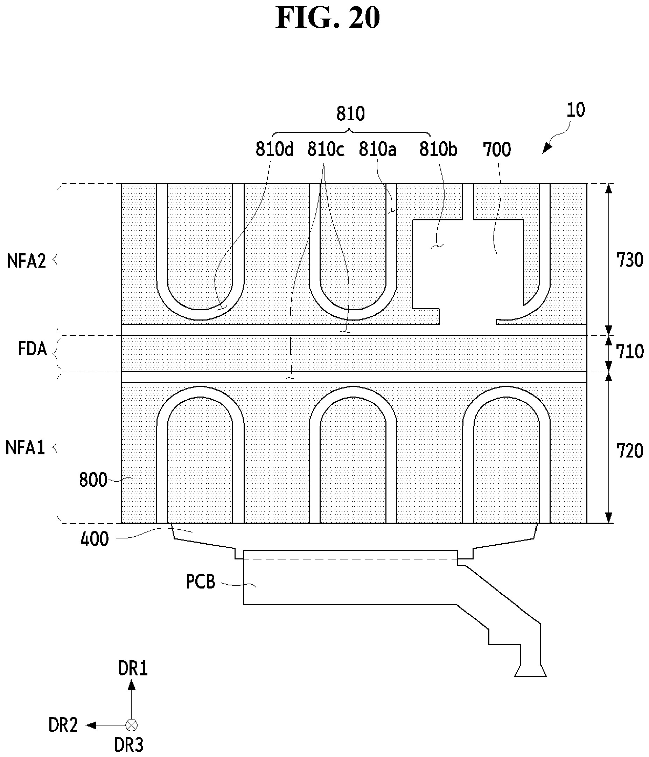

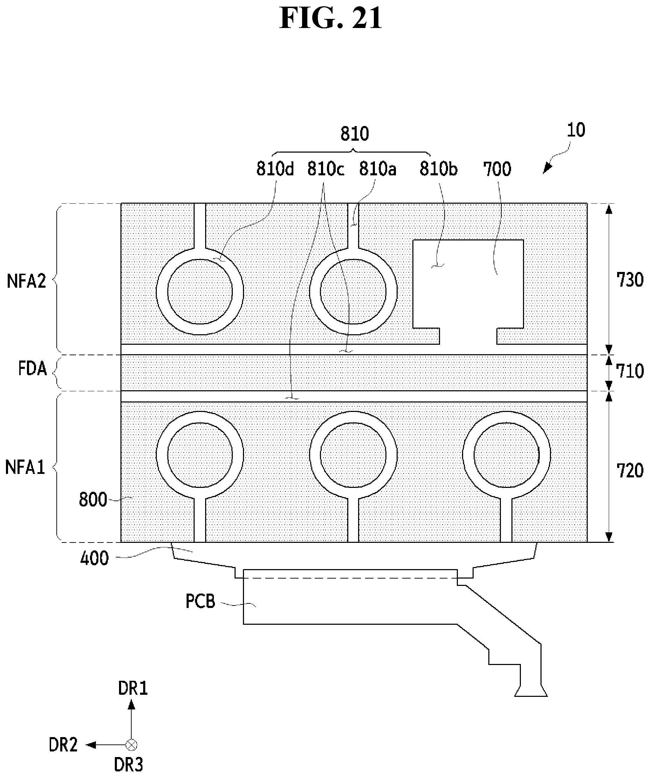

FIG. 20 is a rear view illustrating a display device according to still another embodiment. FIG. 21 is a rear view illustrating a display device according to still another embodiment.

Referring to FIGS. 20 and 21, the shielding film 800 may include a fourth removal area 810d. At least a portion of the fourth removal area 810d may include a curved line on a plane viewed from the third direction DR3 (i.e. plan view). As an example, as illustrated in FIG. 20, the fourth removal area 810d may have a semicircular ring shape. As another example, as illustrated in FIG. 21, the fourth removal area 810d may have a circular ring shape. A shape of the fourth removal area 810d in a plan view is not limited to those illustrated in FIGS. 20 and 21, and may include a curved line of an elliptical shape or other shapes.

In some embodiments, as illustrated in FIG. 20, one fourth removal area 810d may connect at least two adjacent first removal areas 810a to each other. However, the number of first removal areas 810a connected to each other by one fourth removal area 810d is not limited to two, and may also be more than two.

In another embodiment, as illustrated in FIG. 21, one fourth removal area 810d may be connected to one end of one first removal area 810a.

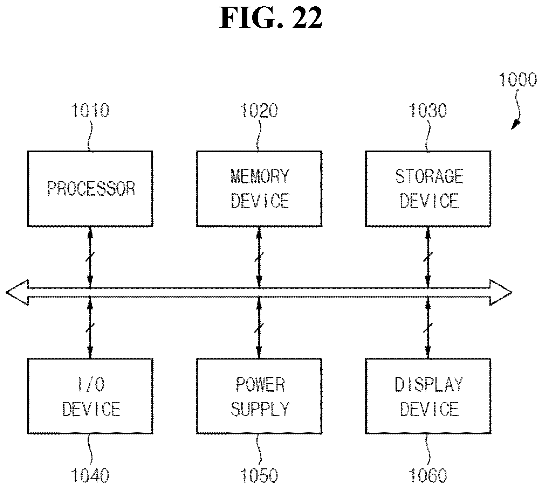

FIG. 22 is a block diagram illustrating an electronic device according to an embodiment.

Referring to FIG. 22, in an embodiment, an electronic device 1000 may include a processor 1010, a memory device 1020, a storage device 1030, an input/output ("I/O") device 1040, a power supply 1050, and a display device 1060. Here, the display device 1060 may correspond to the display device 10 of FIGS. 1 to 21. The electronic device 1000 may further include a plurality of ports for communicating with a video card, a sound card, a memory card, a universal serial bus ("USB") device, or the like. In an embodiment, the electronic device 1000 may be implemented as a television. In another embodiment, the electronic device 1000 may be implemented as a smart phone. However, embodiments are not limited thereto, in another embodiment, the electronic device 1000 may be implemented as a cellular phone, a video phone, a smart pad, a smart watch, a tablet personal computer ("PC"), a car navigation system, a computer monitor, a laptop, a head disposed (e.g., mounted) display ("HMD"), or the like.

The processor 1010 may perform various computing functions. In an embodiment, the processor 1010 may be a microprocessor, a central processing unit ("CPU"), an application processor ("AP"), or the like. The processor 1010 may be coupled to other components via an address bus, a control bus, a data bus, or the like. In an embodiment, the processor 1010 may be coupled to an extended bus such as a peripheral component interconnection ("PCI") bus.

The memory device 1020 may store data for operations of the electronic device 1000. In an embodiment, the memory device 1020 may include at least one non-volatile memory device such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM") device, a ferroelectric random access memory ("FRAM") device, or the like, and/or at least one volatile memory device such as a dynamic random access memory ("DRAM") device, a static random access memory ("SRAM") device, a mobile DRAM device, or the like.

In an embodiment, the storage device 1030 may include a solid state drive ("SSD") device, a hard disk drive ("HDD") device, a CD-ROM device, or the like. In an embodiment, the I/O device 1040 may include an input device such as a keyboard, a keypad, a mouse device, a touchpad, a touch-screen, or the like, and an output device such as a printer, a speaker, or the like.

The power supply 1050 may provide power for operations of the electronic device 1000. The power supply 1050 may provide power to the display device 1060. The display device 1060 may be coupled to other components via the buses or other communication links. In an embodiment, the display device 1060 may be included in the I/O device 1040.

In concluding the detailed description, those skilled in the art will appreciate that many variations and modifications can be made to the preferred embodiments without substantially departing from the principles of the present invention. Therefore, the disclosed preferred embodiments of the invention are used in a generic and descriptive sense only and not for purposes of limitation.

## Claims

1. A display device (10) comprising:
a display panel (400);
a panel support layer (700) disposed under a lower surface of the display panel (400) in a thickness direction (DR3) of the display panel (400); and
a shielding film (800) disposed under a lower surface of the panel support layer (700) in the thickness direction (DR3),
wherein the shielding film (800) includes at least one removal area (810) that is at least one opening exposing the lower surface of the panel support layer (700).

2. The display device (10) of claim 1, wherein one end of the at least one removal area (810) is in contact with one side of the panel support layer (700) in another direction (DR1, DR2) different from the thickness direction (DR3).

3. The display device (10) of claim 1, wherein
the panel support layer (700) includes a folding portion (710) and a non-folding portion (720, 730) disposed on at least one side of the folding portion (710) in another direction (DR1, DR2) different from the thickness direction (DR3), and
the removal area (810) includes a first removal area (810a) disposed on the non-folding portion (720, 730) and a second removal area (810c) disposed adjacent to a boundary between the folding portion (710) and the non-folding portion (720, 730).

4. The display device (10) of claim 3, wherein one end of the first removal area (810a) is in contact with one side of the non-folding portion (720, 730) opposite to the boundary in the other direction (DR1, DR2).

5. The display device (10) of claims 3 or 4, wherein the first removal area (810 a) and the second removal area (810c) extend in different directions from each other.

6. The display device (10) of at least one of claims 3 to 5, wherein the first removal area (810a) and the second removal area (810c) are connected to each other.

7. The display device (10) of at least one of claims 3 to 6, wherein the removal area (810) further includes a third removal area (810b) disposed on the non-folding portion (720, 730).

8. The display device (10) of claim 7, wherein the third removal area (810b) is connected to at least one of the first removal area (810a) and the second removal area (810c).

9. The display device (10) of at least one of claims 3 to 8, wherein
the first removal area (810a) is provided in plurality, and
the removal area (810) further includes a fourth removal area (810d) connecting at least two adjacent first removal areas (810a) of the plurality of first removal areas (810a) to each other.

10. The display device (10) of claim 9, wherein at least a portion of the fourth removal area (810) includes a curved line in a view in the thickness direction (DR3).

11. The display device (10) of at least one of claims 1 to 10, further comprising:
a circuit board (PCB) disposed under a lower surface of the shielding film (800) in the thickness direction (DR3); and
an adhesive member (ADH1, ADH2) disposed between the shielding film (800) and the circuit board (PCB) in the thickness direction (DR3).

12. The display device (10) of claim 11, wherein
the adhesive member (ADH1, ADH2) includes a first adhesive member (ADH1) that does not overlap the removal area (810) in the thickness direction (DR3) and a second adhesive member (ADH2) that overlaps the removal area (810) in the thickness direction (DR3), and
the second adhesive member (ADH2) is spaced apart from the panel support layer (700) with the removal area (810) interposed therebetween in the thickness direction (DR3).

13. The display device (10) of claim 12, wherein the first adhesive member (ADH1) is a double-sided attachment type and the second adhesive member (ADH2) is a single-sided attachment type.

14. The display device (10) of claim 11, wherein the adhesive member (ADH1) is disposed in an area other than an area overlapping the removal area (810) in the thickness direction (DR3).

15. The display device (10) of at least one of claims 1 to 14, wherein the shielding film (800) is a plating layer including copper, titanium, and/or an alloy thereof and/or wherein the shielding film (800) has a thickness of 1 µm to 5 µm in the thickness direction (DR3).

16. The display device (10) of at least one of claims 1 to 15, wherein:
the display panel (400) includes a sub-area bendable in the thickness direction (DR3); and
the display device (10) comprises a circuit board (PCB) overlapping the sub-area and disposed under a lower surface of the shielding film (800) in the thickness direction (DR3) when the display panel (400) is bent.

17. The display device (10) of claim 16, further comprising an adhesive member (ADH2) disposed between the shielding film (800) and the circuit board (PCB) in the thickness direction (DR3),
wherein the adhesive member (ADH2) is spaced apart from the panel support layer (700) with the removal area (810) interposed therebetween in the thickness direction (DR3).

18. An electronic device (1000) comprising:
a display device (10) according to at least one of claims 1 to 17 including a first surface and a second surface opposite to each other in the thickness direction (DR3); and
a power supply (1050) configured to provide power to the display device (10),
wherein the display device (10) further comprises:
a window (200) disposed on the first surface of the display panel (400) in the thickness direction (DR3);
an upper protective film (100) disposed on the window (200) in the thickness direction (DR3);
a lower protective film (500) disposed under the second surface of the display panel (400) in the thickness direction (DR3).
